# EUROPÄISCHE PATENTSCHRIFT

(11) **EP 2 567 000 B1**
(45) Veröffentlichungstag und Bekanntmachung des Hinweises auf die Patenterteilung: **23.04.2014**
(21) Anmeldenummer: 11726642.9
(22) Anmeldetag: 02.05.2011
(51) Int. Cl.: C23C 14/06, C23C 14/34, C22C 1/10, C22C 29/14, C04B 35/58, B22F 3/15

(54) **TITANDIBORID-TARGET**
TITANIUM DIBORIDE TARGET
CIBLE DE PULVÉRISATION EN DIBORURE DE TITANE

(30) Priorität: 04.05.2010 AT 28810 U
(43) Veröffentlichungstag der Anmeldung: 13.03.2013
(73) Patentinhaber: Plansee SE, 6600 Reutte (AT)
(72) Erfinder: O'SULLIVAN, Michael, A-6600 Ehenbichl (AT)
(86) Internationale Anmeldenummer: PCT/AT2011/000209
(87) Internationale Veröffentlichungsnummer: WO 2011/137472

(56) Entgegenhaltungen:
- JP-A- 6 248 446
- KNOTEK O ET AL: "Ceramic cathodes for arc-physical vapour deposition: development and application", SURFACE AND COATINGS TECHNOLOGY, Bd. 49, Nr. 1-3, 10. Dezember 1991 (1991-12-10), Seiten 263-267, XP002651249, ELSEVIER, AMSTERDAM [NL] ISSN: 0257-8972, DOI: 10.1016/0257-8972(91)90066-6 [gefunden am 1991-12-10] in der Anmeldung erwähnt

## Beschreibung

Die Erfindung betrifft ein Titandiborid Target für die physikalische Dampfabscheidung, welches Anteile von einem oder mehreren Metallen aus der Gruppe Eisen, Nickel, Kobalt und Chrom, sowie Kohlenstoff enthält.

Bei Verfahren zur physikalischen Dampfabscheidung, vielfach als PVD-Verfahren (physical vapour deposition) bezeichnet, handelt es sich um Beschichtungsverfahren, bei denen die Beschichtung auf physikalischem Weg durch Verdampfen der schichtbildenden Teilchen aus einem Target, Kondensation des Dampfes und Schichtbildung auf dem zu beschichtenden Substrat, erzeugt wird.

Aufgrund der im Vergleich zu CVD-Verfahren (chemical vapour deposition) niedrigeren Beschichtungstemperatur und in der Regel geringeren Verfahrenskosten, werden PVD-Verfahren in vermehrtem Umfang auch für die Herstellung von Hartstoffschichten bei Werkzeugen für die Zerspanung oder bei Verschleißteilen eingesetzt.

Bei den verschiedenen PVD-Verfahren haben insbesondere Kathodenzerstäubungsverfahren, bei denen das Target durch Ionenbeschuss zerstäubt und in die Dampfphase übergeführt wird oder ARC-PVD-Verfahren, bei dem Atome und Ionen durch eine elektrische Entladung in Form eines Lichtbogens aus der Verdampfungsquelle in die Dampfphase übergeführt werden, in der Praxis besondere Bedeutung erlangt.

Unter Target ist dabei immer die Quelle des zu verdampfenden Materials zu verstehen, welche dann je nach Art des PVD-Verfahrens direkt oder über eine Kathodenhalterung in die Beschichtungsanlage eingebaut wird.

Insbesondere für das ARC-PVD-Verfahren werden die Targets zur besseren Temperaturverteilung vielfach mit einer rückseitigen Kühlplatte versehen, welche entweder mit dem Target formschlüssig in thermisch gut leitendem Kontakt steht oder auch durch ein geeignetes Bondverfahren stoffschlüssig mit dem Target verbunden wird.

Das ARC-PVD-Verfahren hat dabei gegenüber dem Kathodenzerstäubungsverfahren den Vorteil, dass höhere Ionisierungsraten und auch höhere Abscheideraten erreicht werden.

Das Verfahren wird dadurch wirtschaftlicher, die Prozesskontrolle verbessert und durch die höheren energetischen Wachstumsbedingungen wird es möglich die Schichtstruktur positiv zu beeinflussen.

Titandiboridschichten, welche aufgrund ihrer großen Härte und vor allem guten Verschleißfestigkeit häufig als Hartstoffschichten, welche in Kontakt mit Nichteisenmetallen kommen, eingesetzt werden, sind mittels ARC-PVD-Verfahren, jedoch nur sehr schwer herstellbar. Titandiborid weist eine geringe Thermoschockbeständigkeit auf. Da beim ARC-PVD-Verfahren aufgrund des Lichtbogens das Target nur in sehr eng begrenzten räumlichen und zeitlichen Zonen verdampft kommt es durch diese Eigenschaften des Titandiborids zu großen thermischen Spannungen und das Target kann dadurch vorzeitig zerstört werden.

Die Literaturstelle "ceramic cathodes for arc-physical vapour deposition: development and application", O. Knotek, F. Löffler, surface and coating technology 49 (1991), Seiten 263 bis 267, beschreibt die Herstellung von Titandiborid ARC-Targets durch HIPen (hot isostatic pressing) von reinen Titandiboridpulvern, welche mit weniger als 1 Gew.% verschiedener metallischer Zusätze wie Aluminium und Nickel sowie metalloider Zusätze wie Bor und Kohlenstoff versehen sind sowie die Herstellung von Titandiboridschichten unter Verwendung dieser ARC-Verdampfungsquellen.

Unter den Folgerungen der Versuche wird insbesondere ausgeführt, dass die Anwendung des HIP-Verfahrens (hot isostatic pressing) wichtig für die Herstellung von Titandiborid Targets ist, um Beschichtungen über das ARC-PVD-Verfahren herstellen zu können.

Die derart hergestellten Titandiborid Targets weisen aber immer noch nicht die notwendige Thermoschockbeständigkeit auf, welche für ein in der Praxis reibungslos funktionierendes ARC-PVD-Beschichtungsverfahren notwendig wäre.

Aufgabe der vorliegenden Erfindung ist es daher ein Titandiborid Target zu schaffen, welches in der Praxis auch für das ARC-Beschichtungsverfahren problemlos verwendet werden kann.

Erfindungsgemäß wird dies dadurch erreicht, dass die mittlere Korngröße der Titandiborid-Körner zwischen 1 µm und 20 µm liegt, der Kohlenstoffgehalt in einem Bereich von 0,1 bis 5 Gew.% liegt, der Gesamtgehalt von Eisen, Nickel, Kobalt und/ oder Chrom im Bereich von 500 bis 3.000 µg/g liegt und der Kohlenstoff in freier Form an den Korngrenzen der Titandiborid-Körner so verteilt ist, dass die mittleren Abstände zwischen den einzelnen Kohlenstoffteilchen kleiner sind als 20 µm und dass die Porosität weniger als 5 Vol. % beträgt.

Wichtig dabei ist, dass mindestens eine der angegebenen metallischen Anteile innerhalb des angegebenen Bereiches vorhanden ist, wobei natürlich auch weitere niedrigschmelzende metallische Anteile wie Kupfer oder Aluminium vorhanden sein können, welche aber niemals alleine die gewünschte Wirkung erzielen.

Die mittlere Korngröße der Titandiboridkörner wird nach dem Laserbeugungsverfahren bestimmt.

Besonders vorteilhaft dabei ist es, wenn der Kohlenstoffgehalt in einem Bereich von 0,5 bis 3 Gew.% liegt, als metallischer Anteil Eisen im Bereich von 1.000 bis 2.000 µg/g vorliegt und die mittlere Korngröße der TiB₂ Körner zwischen 2 µm und 10 µm beträgt.

Aufgrund der vorliegenden Erfindung hat man festgestellt, dass durch eine völlig gleichmäßige Kohlenstoffverteilung und Verteilung der metallischen Zusätze innerhalb der angegebenen Bereiche Titandiborid Targets geschaffen werden, welche problemlos auch mit dem ARC-PVD-Verfahren verdampft werden können, ohne dass es aufgrund thermischer Spannungen zu einem lokalen oder vollständigen Zerspringen des Targets kommt.

Erreicht wird dies dadurch, dass eine Ausgangspulvermischung aus TiB₂ Pulver und Grafitpulver in einem Mahlaggregat mit Mahlkugeln, die ein oder mehrere Metalle aus der Gruppe Fe, Ni, Co und Cr enthalten, gemahlen wird, bis der Gesamtgehalt aus Fe, Ni, Co und/ oder Cr im Bereich von 500 bis 3000 µg/ g liegt und dass das Verdichten der fertig gemahlenen Pulvermischung durch Heißpressen, bei einem Pressdruck im Bereich von 10 MPa bis 40 MPa und bei einer Temperatur im Bereich von 1.600°C bis 2.000°C, erfolgt.

Wichtig dabei ist, dass die metallischen Anteile nicht als Pulver zugegeben werden, sonder lediglich als Abrieb über die Mahlkugeln, welche zumindest eines der angeführten Metalle enthalten, eingebracht werden.

Besonders vorteilhaft ist das Verfahren dann, wenn die Ausgangspulvermischung aus TiB₂ Pulver und Grafitpulver, in einem Attritor mit Mahlkugeln aus Eisen, gemahlen wird, bis der Eisengehalt im Bereich von 500 bis 3.000 µg/g liegt und das Verdichten der gemahlenen Pulvermischung durch Heißpressen, bei einem Pressdruck im Bereich von 25 bis 35 MPa und einer Temperatur im Bereich von 1.650°C bis 1.850°C, erfolgt.

Der Mahlvorgang dient im Wesentlichen der gleichmäßigen Verteilung des Kohlenstoffes und der metallischen Anteile. Übliche Mahlzeiten mit denen die metallischen Zusätze innerhalb des festgelegten Bereiches eingebracht werden, liegen je nach Art der verwendeten Mühle in einer Größenordnung von 10 bis 120 Minuten. Ein besonders rasches Einbringen wird durch die Verwendung eines Attritors als Mühle erreicht.

Ganz entscheidend für die Herstellung der Targets ist darüber hinaus, dass die Verdichtung der fertig gemahlenen Pulvermischung nicht durch ein HIP-Verfahren, sondern durch Heißpressen innerhalb der angegebenen Pressdrücke und Temperaturen erfolgt. Dadurch kann man auf das beim HIP-Verfahren zum Aufbringen des isostatischen Pressdruckes notwendige Einkannen der Ausgangspulvermischung verzichten, wodurch das Verfahren kostengünstiger wird und vor allem innere Spannungen im verdichteten Target vermieden werden, welche beim HIP-Verfahren aufgrund der sehr unterschiedlichen thermischen Ausdehnungskoeffizienten von Kannungsmaterial, und Titandiborid, auftreten würden.

Der Begriff Heißpressen im Sinne der vorliegenden Erfindung soll dabei alle Varianten des Heißpressens mit oder ohne direkten Stromdurchgang wie beispielsweise das SPS-Verfahren (park plasma sintering) oder das FAST-Verfahren (field assisted sintering technology) mit einschließen.

Im Folgenden wird die Erfindung an Hand von Herstellungsbeispielen und Figuren näher erläutert.

### Beispiel 1

Für Versuchszwecke wurde ein rondenförmiges Target mit 60 mm Durchmesser und 8 mm Dicke erfindungsgemäß hergestellt.

Als Ausgangsmaterial wurde ein Titandiboridpulver mit einem Borgehalt von 30,88 Gew.%, einem Eisengehalt von 0,023 Gew.%, einem Kohlenstoffgehalt von 0,020 Gew.%, Rest Titan, mit einer mittleren Korngröße d 50 von 2,39 µm verwendet.

In einem Topfmischer wurden 1.980 g dieses Titandiboridpulvers unter Zugabe von 20 g Grafit und 2.000 g Isopropanol mit 8.000 g Stahlkugeln, mit einem Durchmesser von 15 mm, 2 Stunden lang gemahlen. Anschließend wurde die Pulvermischung durch Verdampfen des Alkohols getrocknet. Die chemische Analyse ergab einen Eisengehalt von 0,154 Gew.%, was 1540 µg/g entspricht und einen Kohlenstoffgehalt von 1,0 Gew.% in der Pulvermischung. Anschließend wurde die Pulvermischung in einer Heißpresse unter Verwendung von Grafitwerkzeugen bei einem maximalen Pressdruck von 30 MPa und einer maximalen Temperatur von 1.830°C bei einer Haltezeit von 40 min zu einer Ronde mit 60 mm Durchmesser und 8 mm Dicke, verdichtet. Durch das Heißpressen wurde eine Dichte des Materials von 4,4 g/cm³ erreicht, was 98 % der theoretischen Dichte entspricht.

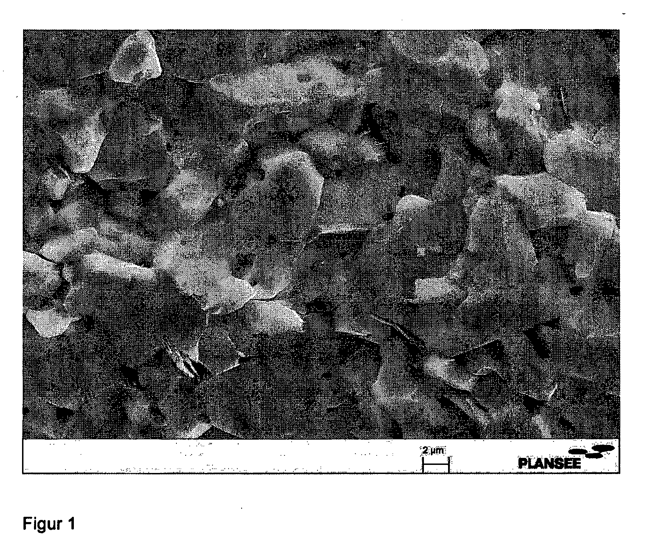

- Figur 1: zeigt die rasterelektronenmikroskopische Aufnahme des Gefüges einer Bruchfläche eines erfindungsgemäßen Targets in 2.500 facher Vergrößerung

Aus der Aufnahme sind deutlich die lamellenförmigen, dunkel gefärbten Grafitpartikel an den Korngrenzen der TiB₂ Körner zu sehen, welche mittlere Abstände in der Größenordnung von 10 µm voneinander aufweisen. Darüber hinaus ist die große Dichte des Gefüges mit einer sehr geringen Porosität zu erkennen.

### Beispiel 2

Für Vergleichszwecke wurde ein Target mit denselben Abmessungen wie in Beispiel 1 mit ähnlichen Herstellungsparametern, jedoch nicht erfindungsgemäß ohne Zugabe von Kohlenstoff hergestellt.

Als Ausgangsmaterial wurde ein Titandiboridpulver mit einem Borgehalt von 31,71 Gew.%, einem Eisengehalt von 0,032 Gew.%, einem Kohlenstoffgehalt von 0,044 Gew.%, Rest Titan, mit einer mittleren Korngröße d 50 von 4,48 µm verwendet.

In einem Topfmischer wurden 200 g dieses Titandiboridpulvers unter Zugabe von 200 g Isopropanol mit 800 g Stahlkugeln, mit einem Durchmesser von 15 mm, 3 Stunden lang gemahlen.

Anschließend wurde das Pulver durch Verdampfen des Alkohols getrocknet. Die chemische Analyse ergab einen Eisengehalt von 0,119 Gew.% was 1190 µg/g entspricht und einen Kohlenstoffgehalt von 0,050 Gew.%. Anschließend wurde das Pulver in einer Heißpresse bei einem maximalen Pressdruck von 30 MPa und einer maximalen Temperatur von 1.800°C bei einer Haltezeit von 20 min verdichtet.

Durch das Heißpressen wurde eine Dichte des Materials von 4,4 g/cm³ erreicht, was 98 % der theoretischen Dichte entspricht.

### Beispiel 3

Für Vergleichszwecke wurden zwei Targets mit denselben Abmessungen wie im Beispiel 1 mit ähnlichen Herstellungsparametern, jedoch nicht erfindungsgemäß ohne Zugabe von Kohlenstoff und ohne Mahlen des Ausgangspulvers hergestellt.

Als Ausgangsmaterial wurde ein Titandiboridpulver mit einem Borgehalt von 31,4 Gew%, einem Eisengehalt von 0,028 Gew.%, einem Kohlenstoffgehalt von 0,042 Gew.%, Rest Titan, mit einer mittleren Korngröße d 50 von 3,81 µm verwendet.

Anschließend wurde das Ausgangspulver in einer Heißpresse einmal mit einem maximalen Pressdruck von 30 MPa und einer maximalen Temperatur von 1.800°C mit einer Haltezeit von 60 min und einmal mit einem maximalen Pressdruck von 30 MPa und einer maximalen Temperatur von 2.200°C mit einer Haltezeit von 30 min verdichtet.

Im ersten Fall wurde durch das Heißpressen ein Target mit einer Dichte des Materials von 3,3 g/cm³ erreicht, was 73 % der theoretischen Dichte entspricht und im zweiten Fall wurde ein Target mit einer Dichte des Materials von 3,4 g/cm³ erreicht, was 76 % der theoretischen Dichte entspricht.

Die nach den Beispielen 1 und 2 hergestellten Targets wurden für Vergleichsversuche in einen Kathodenhalter aus Molybdän mit einer Grafitfolie zur thermischen Kontaktierung eingebaut.

Die entsprechenden Kathoden wurden dann in einer ARC-PVD Anlage mit den folgenden Beschichtungsparametern auf ihr Verhalten untersucht:
- ARC Strom 60 - 70 A
- Spannung 21 V
- Kammertemperatur 24°C
- Prozessdruck 1,5 Pa Argon.

Die nach Beispiel 3 hergestellten Targets wurden aufgrund ihrer geringen Dichte bereits bei der Bearbeitung für den Einbau in den Kathodenhalter zerstört und konnten daher nicht eingesetzt werden.

Das erfindungsgemäß nach Beispiel 1 hergestellte Target hat sich in einem 60 minütigen Betrieb stabil verhalten. Das Target wies keinerlei Risse auf und zeigte eine glatte um 1 bis 2 mm in der Dicke abgetragene Oberfläche.

Das nicht erfindungsgemäß nach dem Beispiel 2 hergestellte Target ist bereits nach wenigen Minuten des Betriebes gerissen und kurz darauf völlig zerstört worden.

Die nach den Vergleichsbeispielen 2 und 3 hergestellten Targets zeigen deutlich, dass sowohl die Zugabe von Kohlenstoff, als auch die gleichmäßige Verteilung geringer Anteile an Eisen, welche ausschließlich durch den Abrieb bei der Mahlung in das Ausgangspulver eingebracht werden, notwenig sind um eine gute Funktionalität der Targets zu gewährleisten.

Die Erfindung ist keinesfalls auf die beschriebenen Herstellungsbeispiele beschränkt. So sind insbesondre auch Targets mit eingeschlossen, welche durch ein Bondverfahren stoffschlüssig mit einer Kühlplatte beispielsweise aus Molybdän verbunden sind.

## Patentansprüche

1. Titandiborid Target für die physikalische Dampfabscheidung, welches Anteile von einem oder mehreren Metallen aus der Gruppe Eisen, Nickel, Kobalt und Chrom, sowie Kohlenstoff enthält,
**dadurch gekennzeichnet,**
**dass**
- die mittlere Korngröße der TiB₂ Körner zwischen 1 µm und 20 µm liegt
- der Kohlenstoffgehalt in einem Bereich von 0,1 bis 5 Gew.% liegt
- der Gesamtgehalt von Fe, Ni, Co und/oder Cr im Bereich von 500 bis 3.000 µg/g liegt
- der Kohlenstoff in freier Form an den Korngrenzen der TiB₂ Körner so verteilt ist, dass die mittleren Abstände zwischen den einzelnen Kohlenstoffteilchen kleiner sind als 20 µm
- die Porosität weniger als 5 Vol.% beträgt.

2. Titandiborid Target nach Anspruch 1, **dadurch gekennzeichnet, dass** der Kohlenstoffgehalt in einem Bereich von
0,5 bis 3 Gew.% liegt.

3. Titandiborid Target nach Anspruch 1 oder 2,
**dadurch gekennzeichnet, dass** die mittlere Korngröße der TiB₂ Körner zwischen 2 µm und 10 µm beträgt.

4. Titandiborid Target nach einem der Ansprüche 1 bis 3, **dadurch gekennzeichnet, dass** es einen Fe-Gehalt im Bereich von 1.000 bis 2.000 µg/g enthält.

5. Verfahren zur Herstellung eines Titandiborid Targets nach einem der Ansprüche 1 bis 3, **dadurch gekennzeichnet, dass** eine Ausgangspulvermischung aus TiB₂ Pulver und Grafitpulver in einem Mahlaggregat mit Mahlkugeln, die ein oder mehrere Metalle aus der Gruppe Fe, Ni, Co und Cr enthalten, gemahlen wird, bis der Gesamtgehalt an Fe, Ni, Co und/oder Cr im Bereich von 500 bis 3.000 µg/g liegt und dass die fertig gemahlene Pulvermischung durch Heißpressen, bei einem Pressdruck im Bereich von 10 MPa bis 40 MPa und einer Temperatur im Bereich von 1.600°C bis 2.000°C, verdichtet wird.

6. Verfahren zur Herstellung einer Titandiborid Verdampfungsquelle nach Anspruch 4, **dadurch gekennzeichnet, dass** eine Ausgangspulvermischung aus TiB₂ Pulver und Grafitpulver in einem Attritor, mit Mahlkugeln aus Eisen, gemahlen wird bis der Eisengehalt im Bereich von 1.000 bis 2.000 µg/g liegt und dass die gemahlene Pulvermischung durch Heißpressen, bei einem Pressdruck im Bereich von 25 bis 35 MPa und einer Temperatur im Bereich von 1.600°C und 1.850°C, verdichtet wird.

## Claims

1. A titanium diboride target for physical vapor deposition, comprising fractions of one or more metals from the group consisting of iron, nickel, cobalt, and chromium, and also comprising carbon,
**characterized**
**in that**
- the average grain size of the TiB₂ grains is between 1 µm and 20 µm
- the carbon content is in a range from 0.1 % to 5% by weight
- the total content of Fe, Ni, Co and/or Cr is in the range from 500 to 3000 µg/g
- the carbon is distributed in free form at the grain boundaries of the TiB₂ grains such that the average distances between the individual carbon particles are less than 20 µm
- the porosity is less than 5% by volume.

2. The titanium diboride target of claim 1, **characterized in that** the carbon content is in a range from 0.5% to 3% by weight.

3. The titanium diboride target of claim 1 or 2, **characterized in that** the average grain size of the TiB₂ grains is between 2 µm and 10 µm.

4. The titanium diboride target of any of claims 1 to 3, **characterized in that** it contains an Fe content in the range from 1000 to 2000 µg/g.

5. A method for producing a titanium diboride target of any of claims 1 to 3, **characterized in that** a starting powder mixture of TiB₂ powder and graphite powder is ground in a grinding assembly with grinding beads which comprise one or more metals from the group consisting of Fe, Ni, Co and Cr until the total amount of Fe, Ni, Co and/or Cr is in the range from 500 to 3000 µg/g, and **in that** the fully ground powder mixture is compacted by hot pressing at a pressing pressure in the range from 10 MPa to 40 MPa and at a temperature in the range from 1600°C to 2000°C.

6. A method for producing a titanium diboride evaporation source of claim 4, **characterized in that** a starting powder mixture of TiB₂ powder and graphite powder is ground in an attritor with iron grinding beads until the iron content is in the range from 1000 to 2000 µg/g, and **in that** the ground powder mixture is compacted by hot pressing, at a pressing pressure in the range from 25 to 35 MPa and at a temperature in the range of 1600°C to 1850°C.

## Revendications

1. Cible en diborure de titane destinée au dépôt physique en phase vapeur, comprenant des proportions d'un ou de plusieurs métaux du groupe fer, nickel, cobalt et chrome, ainsi que du carbone, **caractérisée**
- **en ce que** la taille moyenne des grains de TiB₂ est comprise entre 1 et 20 micromètres,
- que la teneur en carbone est comprise entre 0,1 et 5 pour cent en poids
- que la teneur totale en Fe, Ni, Co et/ou Cr est comprise entre 500 et 3000 microgrammes par gramme,
- que le carbone libre est réparti aux limites des grains de TiB₂ de sorte telle que les distances moyennes entre les différentes particules de carbone sont inférieures à 20 micromètres
- et **en ce que** la porosité est inférieure à 5 pour cent en volume.

2. Cible en diborure de titane selon la revendication 1, **caractérisée en ce que** la teneur en carbone est comprise entre 0,5 et 3 pour cent en poids.

3. Cible en diborure de titane selon la revendication 1 ou 2, **caractérisée en ce que** la taille moyenne des grains de TiB₂ est comprise entre 2 et 10 micromètres.

4. Cible en diborure de titane selon l'une quelconque des revendications 1 à 3, **caractérisée en ce que** la teneur en Fe de ladite cible est comprise entre 1000 et 2000 microgrammes par gramme.

5. Procédé de fabrication d'une cible en diborure de titane selon l'une quelconque des revendications 1 à 3, **caractérisé en ce que** l'on broie, dans une unité de broyage, un mélange initial de poudre de TiB₂ et de poudre de graphite, à l'aide de billes de broyage contenant un ou plusieurs métaux du groupe Fe, Ni, Co et Cr, jusqu'à ce que la teneur totale en Fe, Ni, Co et/ou Cr soit comprise entre 500 et 3000 microgrammes par gramme, et **en ce que** l'on comprime le mélange de poudre broyé, par compression à chaud, à une pression comprise entre 10 et 40 MPa et une température comprise entre 1600 et 2000 degrés Celsius.

6. Procédé de fabrication d'une source de vaporisation au diborure de titane selon la revendication 4, **caractérisé en ce que** l'on broie, dans un attriteur, un mélange initial de poudre de TiB₂ et de poudre de graphite, à l'aide de billes de broyage en fer, jusqu'à ce que la teneur en fer soit comprise entre 1000 et 2000 microgrammes par gramme, et **en ce que** l'on comprime le mélange de poudre broyé, par compression à chaud, à une pression comprise entre 25 et 35 MPa et une température comprise entre 1600 et 1850 degrés Celsius.
